# EUROPEAN PATENT APPLICATION

(11) **EP 4 572 140 A1**
(43) Date of publication of application: **18.06.2025**
(21) Application number: 24215072.0
(22) Date of filing: 25.11.2024
(51) Int. Cl.: H03H 7/19, H03H 11/18

(54) **APPARATUSES, SYSTEMS AND METHODS FOR FACILITATING A PHASE SHIFTER**

(30) Priority: 07.12.2023 US 202318531768
(71) Applicant: NXP USA, Inc., Austin, TX 78735 (US)
(72) Inventor: Yang, Xin, 5656AG Eindhoven (NL); Leenaerts, Dominicus Martinus Wilhelmus, 5656AG Eindhoven (NL)
(74) Representative: Hardingham, Christopher Mark

(57) **Abstract**

Aspects of this disclosure are directed to phase shifters, inclusive of an active 90-degree phase shifter. A phase shifter of this disclosure may include a coupler (201) that generates, from an input signal (RFin), a first signal at a first coupler output (2) and a second signal at a second coupler output (3), a first plurality of transistors (Q2, Q4) coupled to the first coupler output, and a second plurality of transistors (Q3, Q5) coupled to the second coupler output. The first plurality of transistors and the second plurality of transistors may form a multiplexer that implements a nominal 90-degree phase shift in an output signal (RFout) in accordance with a selection via a control signal (PS_ctrl). Other aspects and embodiments are disclosed.

## Description

### FIELD OF THE DISCLOSURE

This present disclosure relates to apparatuses, systems and methods for facilitating a phase shifter.

### BACKGROUND

A phase shifter is a component/device that is useful in many practical applications. For example, a phase shifter may be utilized as part of an analog beamformer (ABF) system, network or application. In many instances, a phase shifter may include fixed phase steps or increments, such as 90 degrees or 180 degrees.

Conventionally, an active vector-modulator (VM) may be used for implementing a phase shifter. However, in practice, VMs have an inherently high noise figure (NF) and low linearity. Moreover, VMs require a high resolution digital-to-analog converter (DAC) for obtaining an accurate phase step control.

In some instances, ABF is implemented using distributed, passive switched-LC phase shifters. However, such arrangements are prone to insertion loss. Further, such arrangements require a silicon on insulator (SOI) switch device with a low figure of merit (FOM), where the FOM may be expressed as the product of resistance and capacitance (e.g., Rₒₙ * C_{off}), to reduce the insertion loss. These issues are even more pronounced in view of the current trends towards greater frequencies in signaling being used. Additionally, amplifiers may be used to compensate for the loss resulting from passive shifters. However, the introduction of such amplifiers results in additional complexity, power dissipation, and chip area (e.g., utilization).

### BRIEF DESCRIPTION OF THE DRAWINGS

Reference will now be made to the accompanying drawings, which are not necessarily drawn to scale, and wherein:
FIG. 1 illustrates a block diagram of a system in accordance with aspects of this disclosure.
FIG. 2 illustrates a circuit for realizing a phase shifter in accordance with aspects of this disclosure.
FIG. 3 illustrates a circuit for implementing a portion of the circuit of FIG. 2.
FIG. 4 illustrates a circuit for implementing a portion of the circuit of FIG. 2.
FIGS. 5A-5C illustrate circuits for realizing a phase shifter in accordance with aspects of this disclosure.
FIG. 6 illustrates a flowchart of an exemplary method in accordance with aspects of this disclosure.

### DETAILED DESCRIPTION

The subject disclosure describes, among other things, illustrative embodiments of a phase shifter. Phase shifters of this disclosure may include a phase-invariant, active, nominal 90-degree phase shifter. A phase shifter of this disclosure may be implemented using components, devices, circuits, and the like, as described in further detail below.

One or more of the exemplary embodiments may include, in whole or in part: a coupler that generates, from an input signal, a first signal at a first coupler output and a second signal at a second coupler output; a first plurality of transistors coupled to the first coupler output; and a second plurality of transistors coupled to the second coupler output, the first plurality of transistors and the second plurality of transistors forming a multiplexer that implements a nominal 90-degree phase shift in an output signal in accordance with a selection via a control signal. One or more of the exemplary embodiments may include, in whole or in part: obtaining an input signal; generating, via a coupler and based on the input signal, an in-phase signal component and a quadrature signal component; and generating, via an active circuit and based on the in-phase signal component and the quadrature signal component, an output signal that provides a nominal 90-degree phase shift in accordance with a selection via a control signal. The output signal may provide a nominal 90-degree phase shift in accordance with a selection via a control signal. Other embodiments are described in further detail below.

By way of introduction, aspects of this disclosure may facilitate a transmit/transmitter (TX) configuration that may be used as part of one or more practical applications, such as for example as part of an integrated circuit (IC) supporting an analog beamformer (ABF). In some embodiments, active circuits may be used to implement major or coarse phase shifting (e.g., between 0-to-180 degrees or 0-to-90 degrees in terms of phase shifts/steps), which may reduce (e.g., eliminate) insertion loss and reduce an amount of chip/IC area that is utilized/needed. Passive circuits may be utilized to facilitate small/fine amounts of phase shifting, potentially avoiding a requirement for a high resolution digital-to-analog converter (DAC).

In accordance with aspects of this disclosure, a phase shifter may include a radio frequency (RF) in-phase (I) and quadrature (Q) signal generation circuit. In some embodiments, a signal selection circuit may be provided that may realize functionality of a multiplexer (MUX) and may feature precise and robust phase shifting control of an output signal with low levels of power dissipation. Bias circuits that may be used in conjunction with the MUX may result in low-valued switching times between different modes of operation which may, in turn, enable rapid and accurate phase shifting operations.

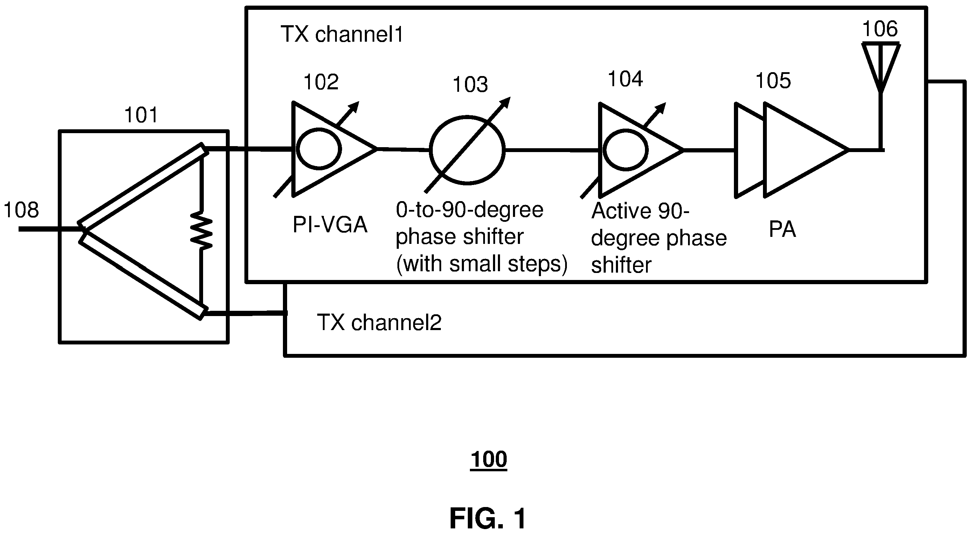

Referring to FIG. 1, a block diagram of a system 100 incorporating a 2-channel TX lineup for potential use as part of an ABF IC is shown. In particular, a first of the channels is denoted as TX channel 1 and a second of the channels is denoted as TX channel 2. The use of two channels is illustrative, which is to say that in some embodiments a different count of channels may be used. Various components that may be utilized as part of TX channel 1 that are illustrated in FIG. 1 are described below, with the understanding that counterpart instances of those components may be utilized in conjunction with TX channel 2.

As part of the system 100, the node 108 may correspond to the input of the 2-channel TX lineup. For example, the input 108 may correspond to a location where an input signal is obtained or provided. The component 101 may correspond to a power divider. The power divider 101 may be implemented in one or more forms, such as via a Wilkinson power divider or another suitable type of power divider. The component 102 may correspond to a phase-inverting variable gain amplifier (PI-VGA), which may provide/support beam gain control and, e.g., 0-to-180 degree phase shifting. In some embodiments, the component 102 may be implemented via a Gilbert cell or another suitable circuit. The component 103 may correspond to a 0-to-90 degree phase shifter and may support small steps or increments (e.g., 5.625, 11.25, ..., 84.375 degree steps). The component 103 may be realized using passive components, e.g., including a passive reflective-type-phase-shifter (RTPS) or a passive delayed-line based phase shifter. The component 104 may correspond to an active 90-degree phase shifter. Various embodiments for implementing the component 104 are described in further detail below. The component 105 may correspond to a single-stage or multi-stage power amplifier. The component 106 may correspond to an antenna that may be used to transmit an output signal.

The series-coupled order or arrangement of various ones of the components shown in FIG. 1 is illustrative, which is to say that other orders/arrangements may be utilized without departing from the scope and spirit of this disclosure. For example, the order or sequence of coupling the components 102, 103, and 104 is exemplary; a series-coupled order of the components such as a sequence of 103, 102, and 104 is representative of another possible order in a direction from the component 100 towards the antenna 106. Additionally, it is noted that various ones of the components, such as for example the component 104, may be utilized in applications that are different from a TX. For example, aspects of the system 100 may be utilized in conjunction with a receive/receiver (RX) lineup, an IQ modulator, etc.

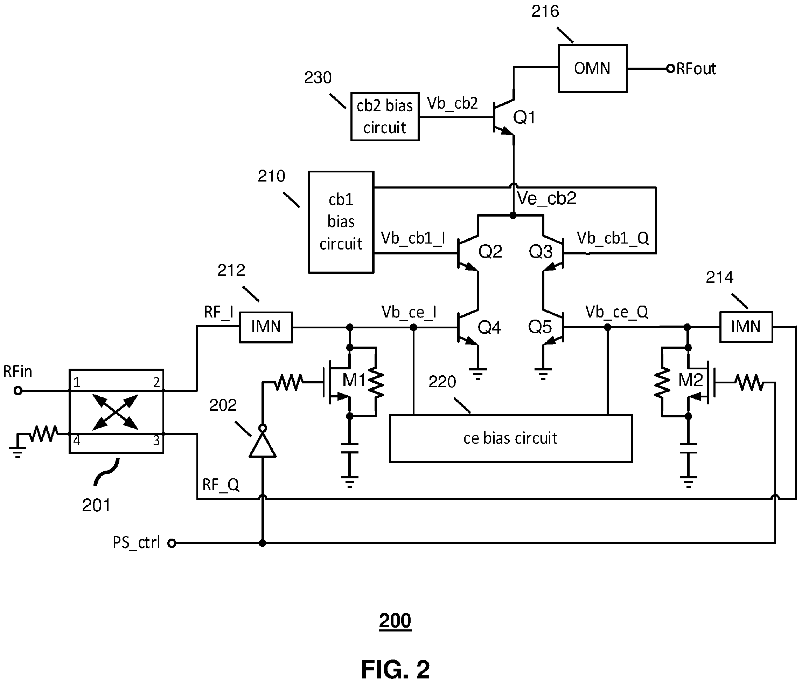

Referring now to FIG. 2, a circuit 200 corresponding to an active 90-degree phase shifter in accordance with aspects of this disclosure is shown. In some embodiments, the circuit 200 may be utilized to realize functionality of the phase shifter 104 of FIG. 1.

Circuit 200 includes a directional coupler 201, a common-base buffer/transistor Q1, an IQ signal selector (including cascode pairs Q2/Q4 and Q3/Q5), and a control circuit. The directional coupler 201 has an input terminal (e.g., terminal 1), first and second coupler output terminals (e.g., terminals 2 and 3), and an isolated terminal (e.g., terminal 4), which may be coupled to ground through an impedance. The first output terminal is coupled through a first input matching network (IMN) 212 to a first node (Vb_ce_I) (i.e., a first input to the IQ signal selector), and the second output terminal is coupled through a second IMN 214 to a second node (Vb_ce_Q) (i.e., a second input to the IQ signal selector).

As part of the circuit 200, the directional coupler 201 may be utilized. The coupler 201 may work as an RF IQ signal generator by splitting an input signal (RFin) received at a coupler input into two signals, and providing those two signals to first and second paths or branches that are coupled to first and second coupler outputs, with a phase difference of 90 degrees between the signals provided to the two paths or branches. For example, these two signal paths/branches are represented as RF_I and RF_Q in FIG. 2, and may be included as part of an I-branch and a Q-branch, respectively, as referred to in further detail below. The circuit 200 may be utilized to generate an output signal (RFout) that may correspond to a selection of one of the two paths. The choice of which of the two paths to utilize as part of generating the output signal RFout may be based on a control/selection signal denoted as PS_ctrl in FIG. 2. More specifically, a control circuit includes a control signal input (PS_ctrl), an inverter 202 (with an inverter input and an inverter output), and first and second impedances. The control input is coupled to the inverter input, and the inverter output is coupled through a first impedance to a control terminal (e.g., base terminal) of a first control transistor, M1. The control input also is coupled through a second impedance to a second control transistor, M2. Transistors M1 and M2 may be, for example, field effect transistors (or other types of transistors) with a first current conducting terminal coupled to the first or second input node (Vb_ce_I or Vb_ce_Q) and a second current conducting terminal coupled through a DC blocking capacitor to ground.

As used herein, reference to a transistor being turned "ON" means that a control signal at a control terminal (e.g., a base terminal) of the transistor causes the transistor to be in a low impedance state (i.e., allowing current flow between emitter and collector terminals). Conversely, reference to a transistor being turned "OFF" means that a control signal at the control terminal of the transistor causes the transistor to be in a high impedance state (i.e., preventing current flow between emitter and collector terminals).

The transistors Q2, Q3, Q4, and Q5 shown in FIG. 2 may function as an IQ signal selection (e.g., may function as a 2-to-1 MUX that selects between input signals RF_I and RF_Q). Transistors Q2 and Q4 are coupled in a cascode relationship with the collector of transistor Q2 being coupled to an output node (Ve_cb2), the emitter of transistor Q2 being coupled to the collector of transistor Q4, and the emitter of transistor Q4 being coupled to ground. The base of transistor Q4 is coupled to the first input node (Vb_ce_I) and to a collector/emitter bias circuit 220, and the base of transistor Q2 is coupled to a first collector/base bias circuit 210. Similarly, transistors Q3 and Q5 are coupled in a cascode relationship with the collector of transistor Q3 being coupled to the output node (Ve_cb2), the emitter of transistor Q3 being coupled to the collector of transistor Q5, and the emitter of transistor Q5 being coupled to ground. The base of transistor Q5 is coupled to the second input node (Vb_ce_Q) and to the collector/emitter bias circuit 220, and the base of transistor Q3 is coupled to the first collector/base bias circuit 210. The emitter of transistor Q1 is coupled to the collectors of transistors Q2 and Q3 (or the output node (Ve_cb2)), and the emitter of transistor Q1 is coupled through the OMN 216 to the RF output (RFout). The base of transistor Q1 is coupled to a second collector base bias circuit 230.

In a first mode of operation of the circuit 200, corresponding to a selection of the I-branch, the transistors Q2 and Q4 may be turned ON, with the voltage at the node Vb_ce_I approximately equal to the turn-on voltage (approximately 0.8V) of the base-emitter of transistor Q4 (represented hereinafter as Vbe) and the node Vb_cb1_I approximately equal to twice that amount (e.g., 1.6V). In this first mode of operation, the transistor/switch M1 may be turned OFF (via the control signal PS_ctrl, by way of the inverter 202). In the first mode of operation, the Q-branch transistors Q3 and Q5 may be turned OFF, with the voltage at the nodes Vb_ce_Q and Vb_cb1_Q being equal and approximately at 0V. In the first mode of operation, the transistor/switch M2 may be turned ON (via the control signal PS_ctrl).

The second mode of operation of the circuit 200 may correspond to a selection of the Q-branch. The second mode of operation may represent the mirror image of the first mode of operation described above. A skilled artisan would appreciate how to exercise the various signals/nodes to achieve the second mode of operation, and so, a complete description is omitted herein for the sake of brevity. In brief, in the second mode of operation, the I-branch transistors Q2 and Q4 may be turned OFF, the transistor/switch M1 may be turned ON, the Q-branch transistors Q3 and Q5 may be turned ON, and the transistor/switch M2 may be turned OFF.

Regardless of which of the I-branch or the Q-branch is selected, the transistor Q1 may always be turned ON (with the value of the voltage at node Vb_cb2 approximately equal to three times the value of Vbe, or approximately 2.4V - the cb2 bias circuit 230 may be configured to provide the voltage Vb_cb2 and may correspond to a fixed DC power supply or the like; in this regard, it is noted that the referenced value is exemplary and may be a function of the type or technology of transistors or switches that are used in a given embodiment). Switching between the two branches may result in a signal at the output RFout having a 90-degree phase difference. As such, the circuit 200 may be utilized to realize an active 90-degree phase shifter.

The switching or MUX topology provided by the circuit 200 may provide high quality isolation between the I-branch and Q-branch. In this manner, a precise and robust phase control may be obtained at the output RFout. For example, as part of the first mode of operation described above (when transistors Q2 and Q4 are turned ON and the transistors Q3 and Q5 are turned OFF), the I-branch signal may be (substantially) prevented from leaking to the Q-branch components (e.g., from the node Ve_cb2 to the node Vb_ce_Q). Additionally, the common-base buffer/transistor Q1 may provide a low-Ohmic load impedance for the turned-on cascode pair of transistors Q2 and Q4, while the turned-off pair of transistors Q3 and Q5 has a high output impedance, further serving to preclude the I-branch signal from leaking into the Q-branch. Similar remarks apply in respect of the second mode of operation (corresponding to a selection of the Q-branch).

As one skilled in the art will appreciate based on a review of this disclosure, the switches/transistors M1 and M2 may be used to achieve a constant input impedance of, e.g., the transistors Q4 and Q5 between ON and OFF states, so that the directional coupler 201 may have a (substantially) constant load impedance between the first and second output terminals of the coupler 201 (labeled 2 and 3) between the first and second modes of operation (or, in other words, when realizing different phase shifts/settings). Furthermore, it is appreciated that since the switches M1 and M2 may be utilized/applied to compensate for changes in input impedance that they are not required to provide a good/high-quality short/open status. Thus, the FOM of the switches M1 and M2 is not critical, lending to flexibility in a selection of (parameters for) the switches M1 and M2.

Even without the use of the switches M1 and M2, aspects of the circuit 200 may be utilized to realize an active phase shifter. The trade-off in omitting the switches M1 and M2 is that the phase shift realized in practice might not be 90 degrees, but may be approximately 92 or 93 degrees (providing for a variation of approximately plus-or-minus 2%). More generally, a range may be realized of the form 90 degrees plus-or-minus X, where X is some value (e.g., X is 1 degree, 2 degrees, 3 degrees, etc.). In this respect, phase shifters of this disclosure may be utilized to realize a nominal 90-degree phase shift, where the term nominal in this context conveys the notion that the phase shift may be approximately, but might not be exactly, equal to 90 degrees.

The circuit 200 may include a first input matching network (IMN) 212 and a second IMN 214, associated with the I-branch and Q-branch, respectively. The circuit 200 may include an output matching network (OMN) 216 at the output (RFout). The IMNs 212 and 214 and the OMN 216 may be used to provide impedance matching, may reduce the likelihood or extent of signal reflections, etc., as would be understood and appreciated by one skilled in the art.

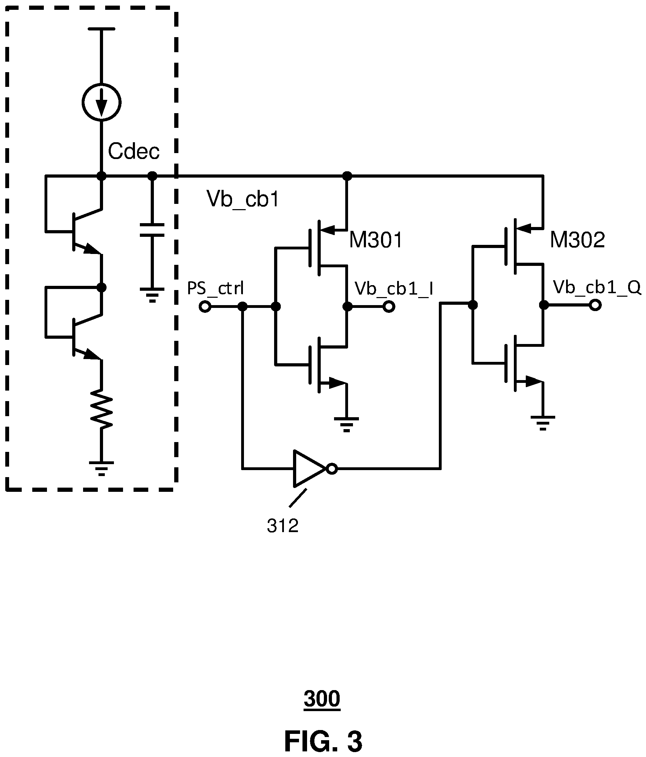

Referring now to FIG. 3, a circuit 300 is shown. The circuit 300 may be used to realize or implement the cb1 bias circuit 210 shown in FIG. 2. The circuit 300 (in conjunction with the circuit 200) may be used to realize nano-second latency and fast beam steering capabilities (e.g., switching or steering on the order of 5 nanoseconds). The portion of the circuit 300 included within the dashed box that is superimposed may correspond to a cascode bias circuit and may generate a voltage Vb_cb1 of approximately 1.6V. To facilitate the rapid switching referenced above, the sources of transistors/switches M301 and M302 may be connected together at the node represented by Vb_cb1. Since the transistors/switches M301 and M302 may be complementary in nature (e.g., one of the transistors/switches M301 and M302 may be ON, while the other of the transistors/switches M301 and M302 may be OFF, as fairly represented by operation of the control signal PS_ctrl and inverter 312 [where the inverter 312 may correspond to the inverter 202 in a given embodiment]), electric charge may travel between the nodes Vb_cb1_I and Vb_cb1_Q. Hence, there might not be much charging and discharging of the decoupling capacitor Cdec and the voltage Vb_cb1 may be (substantially) constant between the first and second modes of operation described above.

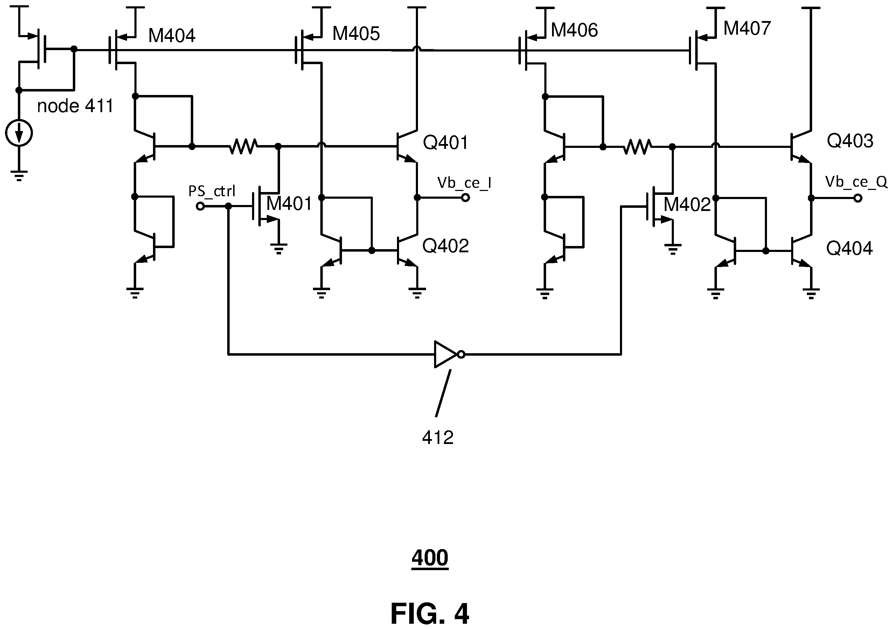

Referring now to FIG. 4, a circuit 400 is shown. The circuit 400 may be used to realize or implement the ce bias circuit 220 shown in FIG. 2. Much like the circuit 300 described above, the circuit 400 (in conjunction with the circuit 200) may be used to realize nano-second latency and fast beam steering capabilities (e.g., switching or steering on the order of 5 nanoseconds).

The switches/transistors M401 and M402 shown in FIG. 4 may be used to pull down the bias voltages Vb_ce_I and Vb_ce_Q. The switches/transistors M401 and M402 may be complementary in nature (e.g., one of the switches/transistors M401 and M402 may be ON, while the other of the switches/transistors M401 and M402 may be OFF, as fairly represented by operation of the control signal PS_ctrl and inverter 412 [where the inverter 412 may correspond to the inverter 202 or the inverter 312 in a given embodiment]) so that the voltages Vb_ce_I and Vb_ce_Q will be opposite in magnitude/polarity (to facilitate turning one of transistors Q4 and Q5 ON and the other of transistors Q4 and Q5 OFF, in the manner described above in relation to the circuit 200 of FIG. 2).

As part of the circuit 400, the transistor Q401 may source current and increase the bias voltage Vb_ce_I in one mode of operation and the transistor Q402 may sink current and pull down the bias voltage Vb_ce_1 (to approximately 0V) in another mode of operation. Similar remarks apply in respect of the bias voltage Vb_ce_Q vis-à-vis the transistors Q403 and Q404.

The current mirror transistors M404, M405, M406, and M407 may share a same/common gate connection at a node 411. With such a configuration, electric charge may mainly travel between transistors M404 and M406, and thus, the voltage at the node 411 may remain (substantially) constant when switching between the I-branch and the Q-branch as described above.

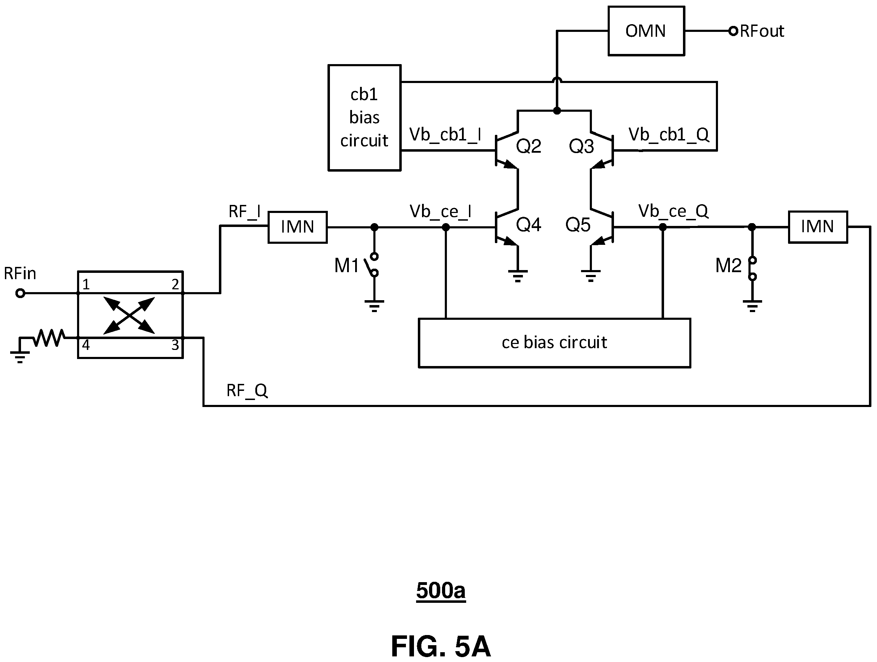

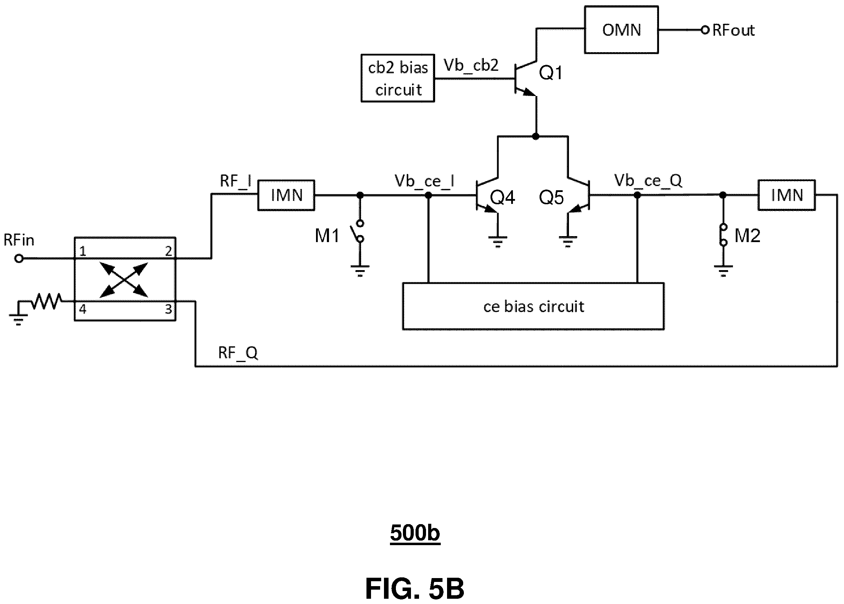

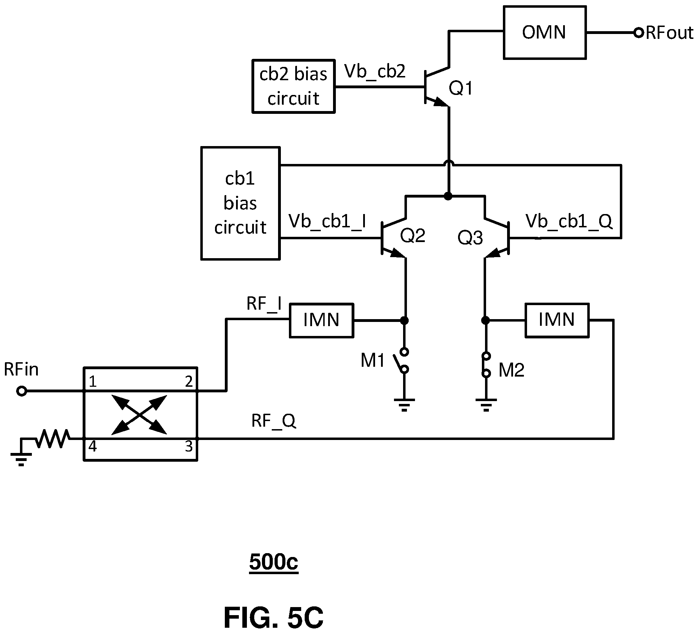

Having just described the circuit 200 (and select ones of its components by way of the description above in respect of the circuit 300 and the circuit 400), it is appreciated that there may be variants of the circuit 200 that may be utilized in a given embodiment. For example, and with reference to FIGS. 5A, 5B, and 5C, circuits 500a, 500b, and 500c are shown that may correspond to variants of the circuit 200. In FIGS. 5A-5C, and relative to FIG. 2, some of the labels of the components are omitted for the sake of simplicity in illustration (e.g., one skilled in the art will appreciate the correspondence between components shown in FIGS. 5A-5C and components shown in FIG. 2). Further, in terms of notation or symbology, the switches/transistors M1 and M2 (and associated components, such as resistors or capacitors coupled thereto) are simplified in FIGS. 5A-5C relative to what is shown in FIG. 2. Differences between each of the circuits 500a, 500b, and 500c, relative to the circuit 200, are described in detail below.

Relative to the circuit 200, the circuit 500a may omit the top, stacking cb2 stage (inclusive of the transistor Q1 and the cb2 bias circuit 230). Relative to the circuit 200, the circuit 500b may omit the middle, stacking cb 1 stage (inclusive of the transistors Q2 and Q3 and the cb1 bias circuit 210). Relative to the circuit 200, the circuit 500c may omit the bottom, stacking ce stage (inclusive of the transistors Q4 and Q5 and the ce bias circuit 220).

Thus, the configurations shown in FIGS. 5A-5C in respect of the circuits 500a, 500b, and 500c may utilize a double-stacking configuration (compared to the circuit 200 that utilizes a triple-stacking configuration) by way of the omission of a stage/stack in each of the circuits 500a, 500b, and 500c as described above. The circuits 500a, 500b, and 500c may be particularly useful or applicable in relation to low-voltage (transistor/switch) environments or technologies (e.g., 1.5V, 1.8V, etc.), whereas the circuit 200 may be more appropriate for use with higher-valued voltage environments or technologies (e.g., 3.3V or greater). With less stacking, the circuits 500a, 500b, and 500c may provide less isolation, and provide for a less robust control of output phase shifting, relative to the circuit 200.

While the various circuits 200, 300, 400, 500a, 500b, and 500c that are depicted in the accompanying drawing figures demonstrate a use of various switches or transistors (including, for example, M1, M2, Q1, Q2, Q3, Q4, and Q5 in the case of the circuit 200 FIG. 2) as being of a particular type or technology (e.g., an NPN transistor in the case of Q1, Q2, Q3, Q4, and Q5), it is appreciated that other types or technologies may be used (e.g., MOS, HBT, HEMT, etc.) without departing from the scope and spirit of this disclosure. In this respect, the particular form or type of the switches or transistors shown as part of the circuits 200, 300, 400, 500a, 500b, and 500c is treated as illustrative or exemplary (as opposed to limiting). Similarly, any values for, e.g., voltage or current are illustrative/exemplary, and different values may be utilized/provided without departing from the scope and spirit of this disclosure.

Various devices, components, signals, etc., of this disclosure may be coupled to one another, such as is demonstrated in the accompanying drawing figures. A coupling in this context may refer to a direct connection or an indirect connection. An indirect connection between a first entity or signal and a second entity or signal may include at least one intervening entity or signal.

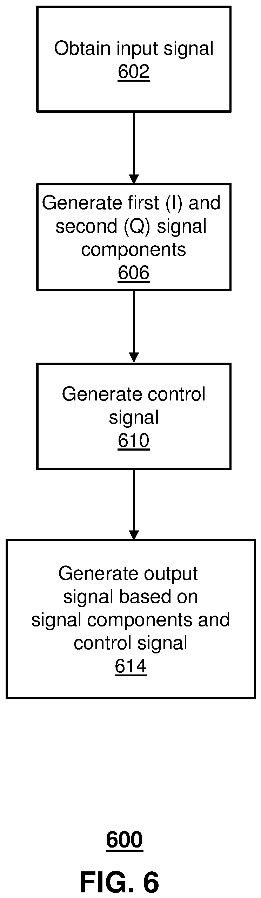

Referring now to FIG. 6, a flowchart of an exemplary method 600 in accordance with various aspects described herein is shown. The method 600 may be utilized (e.g. implemented or executed) to realize functionality of a phase shifter. The method 600 is described below in respect of operations associated with the various blocks shown in FIG. 6. It is understood and appreciated that aspects of some of the operations/blocks shown may be optional in some embodiments. Further, in some embodiments additional operations/blocks not shown may be included. Still further, the order or sequence of the operations/blocks may be different from what is explicitly shown.

In block 602, an input signal may be obtained. For example, and briefly referring to, e.g., FIG. 2 the input signal of block 602 may correspond to the signal at RFin. As part of block 602, the signal may be acquired from a source or distributor of the signal (as potentially subject to modification, processing, conditioning, or the like). In some embodiments, block 602 may include generating the input signal in the first instance (such as, for example, via a signal generator).

In block 606, the input signal (of block 602) may be processed to generate first and second signals. For example, the first signal of block 606 may correspond to an in-phase (I) signal component and the second signal of block 606 may correspond to a quadrature (Q) signal component. Briefly referring to, e.g., FIG. 2, the processing (e.g., dividing) of the input signal in block 606 may be facilitated via the coupler 201.

In block 610, a control or selection signal may be generated. Parameters of the control/selection signal of block 610 (which, in some embodiments, may correspond to the control signal PS_ctrl referenced above), such as for example timing or frequency parameters, may be selected based on an identifier/identification of a particular environment or practical application at hand where the phase shifter is used. For example, it may be the case that in a first practical application involving a TX lineup or RX lineup a first frequency should be used, whereas in a second practical application involving an IQ modulator a second frequency should be used, the second frequency being the same as, or different from, the first frequency.

In block 614, an output signal may be generated based on the control signal of block 610. For example, block 614 may include a selection, via the control signal, of one of two signals or paths (corresponding to the first and second signals of block 606) via a MUX (e.g., in the context of FIG. 2, the MUX formed via the transistors Q2, Q3, Q4, and Q5) or the like that may serve to generate the output signal (e.g., in the context of FIG. 2, the signal at RFout).

Aspects of this disclosure may be implemented via one or more processing systems. Each processing system may include one or more processors. Aspects of this disclosure may be implemented utilizing transitory and/or non-transitory computer-readable mediums or machines. For example, aspects of this disclosure may include a computer-readable medium (or a memory) that has stored thereon executable instructions; the instructions, when executed (by, e.g., a processing system) may facilitate a performance of one or more operations, such as for example one or more of the operations described herein.

The present disclosure extends to A system comprising: a phase-inverting variable gain amplifier (PI-VGA) that provides 0-to-180 degree phase shifting; a 0-to-90 degree phase shifter implemented via passive components; and an active 90-degree phase shifter. The system may further comprise a power divider that divides an input signal; The system may further comprise a power amplifier (PA). The system may further comprise an antenna that transmits an output signal, wherein the output signal is based on the input signal, and wherein the input signal is processed via at least the power divider, the PI-VGA, the 0-to-90 degree phase shifter, the active 90-degree phase shifter, and the PAin generating the output signal.

As set forth herein, aspects of this disclosure represent substantial improvements to technologies associated with practical applications. To demonstrate, and as set forth above, aspects of this disclosure may facilitate rapid switching in respect of phase shifters, while also providing for high levels of signal isolation. Furthermore, due to some devices or components (e.g., switches or transistors) being selectively turned OFF, power dissipation may be reduced (e.g., minimized). For at least these reasons, one skilled in the art will appreciate that the various aspects of this disclosure are not directed to abstract ideas. To the contrary, and as demonstrated herein, the various aspects of this disclosure are directed to, and encompass, significantly more than any abstract idea standing alone.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated to achieve the same purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features from one or more embodiments can be combined with one or more features of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A circuit comprising:
a coupler with a first coupler output and a second coupler output, wherein the coupler generates, from an input signal, a first signal at the first coupler output and a second signal at the second coupler output;
a first plurality of transistors coupled to the first coupler output; and
a second plurality of transistors coupled to the second coupler output, the first plurality of transistors and the second plurality of transistors forming a multiplexer that implements a nominal 90-degree phase shift in an output signal in accordance with a selection via a control signal received at a control signal input.

2. The circuit of claim 1, further comprising:
a transistor that is coupled to a first transistor of the first plurality of transistors and a first transistor of the second plurality of transistors.

3. The circuit of claim 2, further comprising:
a first bias circuit that supplies a first bias voltage to the first transistor of the first plurality of transistors and a second bias voltage to the first transistor of the second plurality of transistors.

4. The circuit of claim 3, further comprising:
a second bias circuit that supplies a third bias voltage to the transistor.

5. The circuit of claim 3 or 4, further comprising:
a first input matching network disposed between the first coupler output and a second transistor of the first plurality of transistors; and
a second input matching network disposed between the second coupler output and a second transistor of the second plurality of transistors.

6. The circuit of claim 5, further comprising:
a second bias circuit that supplies a third bias voltage to the second transistor of the first plurality of transistors and a fourth bias voltage to the second transistor of the second plurality of transistors.

7. The circuit of any preceding claim, wherein the nominal 90-degree phase shift corresponds to a phase shift of 90 degrees plus-or-minus 3 degrees.

8. The circuit of any preceding claim, further comprising:
a first switch coupled to the first coupler output and the first plurality of transistors; and
a second switch coupled to the second coupler output and the second plurality of transistors.

9. The circuit of claim 8, wherein the second switch is coupled to the control signal input.

10. The circuit of claim 9, further comprising:
an inverter that generates, at an inverter output, an inverted control signal from the control signal,
wherein the first switch is coupled to the inverter output.

11. The circuit of any preceding claim, wherein each transistor of the first plurality of transistors and the second plurality of transistors is an NPN transistor.

12. The circuit of claim 11, wherein an emitter of a first transistor of the first plurality of transistors is connected to a collector of a second transistor of the first plurality of transistors.

13. The circuit of claim 12, wherein an emitter of a first transistor of the second plurality of transistors is connected to a collector of a second transistor of the second plurality of transistors.

14. A method comprising:
obtaining an input signal;
generating, via a coupler and based on the input signal, an in-phase signal component and a quadrature signal component; and
generating, via an active circuit and based on the in-phase signal component and the quadrature signal component, an output signal that provides a nominal 90-degree phase shift in accordance with a selection via a control signal.

15. The method of claim 14, wherein the active circuit includes a plurality of transistors arranged in at least a double-stacking configuration.
